# EUROPEAN PATENT SPECIFICATION

(11) **EP 0 328 346 B1**
(45) Date of publication and mention of the grant of the patent: **02.11.1994**
(21) Application number: 89301173.4
(22) Date of filing: 07.02.1989
(51) Int. Cl.: H04N 5/21, H03G 7/00

(54) **Noise reduction circuits**
Schaltungen zur Rauschverminderung
Circuits de réduction de bruit

(30) Priority: 10.02.1988 JP 29824/88
(43) Date of publication of application: 16.08.1989
(73) Proprietor: SONY CORPORATION, Tokyo 141 (JP)
(72) Inventor: Matsumoto, Hiroaki c/o Patents Division, Shinagawa-ku Tokyo 141 (JP); Senda, Tetsuya c/o Patents Division, Shinagawa-ku Tokyo 141 (JP); Fukuda, Tokuya c/o Patents Division, Shinagawa-ku Tokyo 141 (JP)
(74) Representative: Thomas, Christopher Hugo

(56) References cited:
- GB-A- 2 052 220
- GB-A- 2 142 204
- GB-A- 2 179 820
- US-A- 3 278 866
- PATENT ABSTRACTS OF JAPAN, vol. 12, no. 234 (E-629)[3081], 5th July 1988; JP-A-63 26 168 (TOSHIBA) 03.02.1988

## Description

This invention relates to noise reduction circuits and, more particularly, but not exclusively, to circuits for suppressing noise contained in a signal having a relatively broad frequency band, such as the luminance signal portion of a composite video signal.

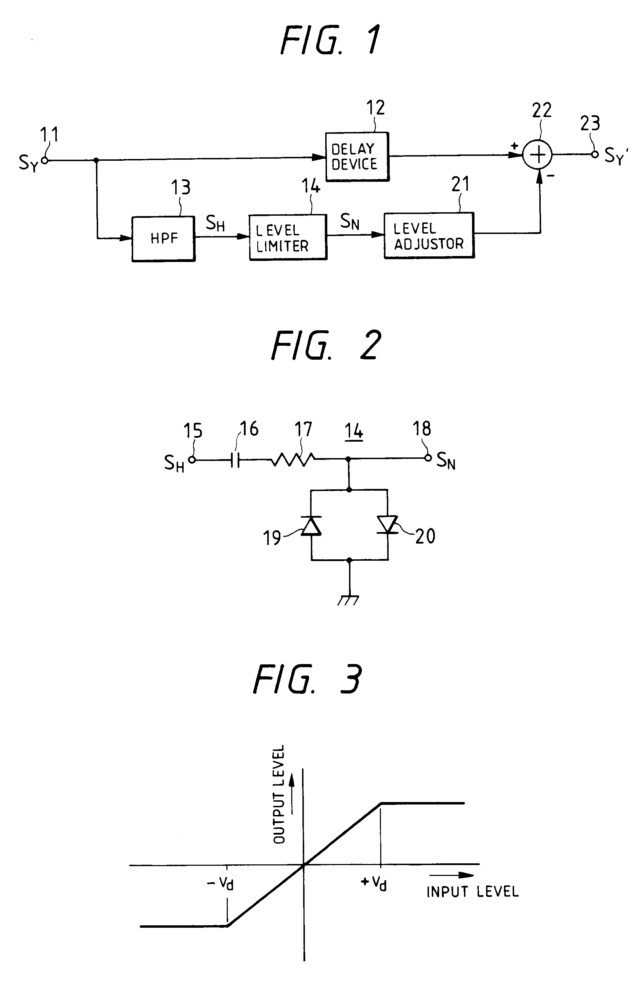

In a video signal processing circuit employed in a video camera, video tape recorder, television receiver or the like handling a video signal, the luminance signal portion of the composite video signal is subjected to noise reduction for suppressing noise contained in the luminance signal so that a picture reproduced from the video signal is improved in quality. In a previously proposed circuit for the reduction of noise in the luminance signal, a noise suppressing signal is produced on the basis of a high frequency component of the luminance signal which contains noise. The noise suppressing signal is added with reversed polarity to the luminance signal so as to cancel noise contained in the luminance signal. Such a previously proposed noise reduction circuit is shown in Figure 1.

Referring to Figure 1, a luminance signal SY received at an input terminal 11 is supplied to both a delay device 12 and a high-pass filter (HPF) 13, and a high frequency component SH of the luminance signal SY which contains noise is obtained from the HPF 13. The high frequency component SH from the HPF 13 is supplied to a level limiter 14. The level limiter 14 comprises, as Figure 2 shows, an input terminal 15 to which the high frequency component SH is applied, a capacitor 16 and a resistor 17 connected in series to the terminal 15, an output terminal 18 connected to the terminal 15 through the series-connected capacitor 16 and resistor 17, and a pair of diodes 19 and 20 connected in anti-parallel with each other between the terminal 18 and a reference potential terminal which may, for example, be earthed.

The level limiter 14 has an input-output characteristic as shown in Figure 3. When an input level is within a range such that a signal voltage level applied to both of the diodes 19 and 20 is equal to or lower than a forward voltage drop +vd at the diode 19 and equal to or higher than a forward voltage drop -vd at the diode 20, an output level proportional to the input level is obtained. On the other hand, when the input level is such that the signal voltage level applied to both of the diodes 19 and 20 is either higher than the forward voltage drop +vd at the diode 19 or lower than the forward voltage drop -vd at the diode 20, an output level having a constant positive or negative value is obtained.

Accordingly, at the terminal 18, a signal having a relatively large level and containing mainly noise is derived from the high frequency component SH. This derived signal is identified in Figures 1 and 2 as SN. The noise suppressing signal SN is adjusted in level by a level adjuster 21 having a predetermined gain, and is supplied to the negative input terminal of a subtracter 22.

The luminance signal SY from the terminal 11 is delayed by the delay device 12 so as to coincide in time with the noise suppressing signal SN from the level adjuster 21 and then supplied to the positive input terminal of the subtracter 22. In the subtracter 22, the noise suppressing signal SN is added with reversed polarity to (that is, subtracted from) the luminance signal SY delayed by the delay device 12, so that the noise contained in the luminance signal SY is cancelled by the level-adjusted noise suppressing signal SN. As a result, a luminance signal SY′ in which noise is suppressed is obtained from the subtracter 22 to be supplied to the terminal 23.

In the noise suppression of the luminance signal SY carried out in the noise reduction circuit of Figure 1, both of the limit levels set by the level limiter 14 and the gain of the level adjuster 21 are usually kept constant.

Accordingly, when the level of the luminance signal SY is relatively high, the noise contained in the luminance signal SY has a relatively low level, and therefore the high frequency component SH derived from the HPF 13 contains noise of relatively low amplitude. On the other hand, when the level of the luminance signal SY is relatively low, the noise contained in the luminance signal SY has a relatively high level, and therefore the high frequency component SH derived from the HPF 13 contains noise of relatively high amplitude.

With the limit levels set to a constant value by the level limiter 14, certain problems arise. In particular, noise having a relatively low level and a large amount of luminance signal component pass through the level limiter 14 to produce the noise suppressing signal SN when the noise contained in the luminance signal SY has a relatively low level, and noise in the high frequency component SH does not pass sufficiently through the level limiter 14 to produce the noise suppressing signal SN when the noise contained in the luminance signal SY has a relatively high level. Moreover, in the case where the noise suppressing signal SN includes noise having a relatively low level and a large amount of luminance signal component, the luminance signal SY′ obtained from the subtracter 22 is noticeably lacking in a high frequency component thereof, and in the case where the noise suppressing signal SN does not include a sufficient amount of noise having the relatively high level and having passed through the level limiter 14, the luminance signal SY′ obtained from the subtracter 22 includes noise that is not suppressed sufficiently.

Further, in a situation where the gain of the level adjuster 21 is set to be constant, the noise contained in the luminance signal SY may be suppressed improperly by the noise suppressing signal SN in the subtracter 22 because of variations in the level of the noise occurring together with variations in the level of the luminance signal SY. The luminance signal SY′ obtained at the output terminal 23 may therefore include noise that is insufficiently suppressed.

An example of a noise reduction circuit of the general type described above is disclosed in UK patent application number GB-A-2 179 820. That patent application is specifically concerned with reducing the period for which noise reduction is ineffective following a large signal jump, and, to this end, the time constant of the high-pass filter is switchable in response to a jump in the signal level.

According to the present invention there is provided a noise reduction circuit for reducing noise contained in an input signal, the circuit comprising:
input means for receiving an input signal that includes a signal component containing noise;
filter means connected to said input means for receiving the input signal and extracting the signal component containing noise from the input signal;
level limiting means connected to said filter means for limiting a level of the signal component extracted by said filter means to produce a noise suppressing signal;
level adjusting means connected to said level limiting means for adjusting a level of the noise suppressing signal;
signal subtracting means connected to said input means and said level adjusting means and responsive to the input signal and the noise suppressing signal from said level adjusting means so that the noise suppressing signal is added with reversed polarity to the input signal so as to suppress the noise contained in the input signal; and
output means connected to said signal subtracting means for supplying an output signal derived from said signal subtracting means;
characterized by:
said level limiting means being a variable level limiting means;
level detecting means connected to said input means for receiving the input signal and producing a detection signal indicating a level of the input signal; and
control signal generating means connected to said level detecting means for generating first and second control signals in response to said detection signal, supplying said first control signal to said variable level limiting means so as to control a limit level of said variable level limiting means, and supplying said second control signal to said level adjusting means so as to control a gain of said level adjusting means, wherein said control signal generating means adjusts said first control signal so as to decrease an absolute value of said limit level in response to an increase in the level of the input signal and to increase the absolute value of said limit level in response to a decrease in the level of the input signal, and adjusts said second control signal so as to decrease the gain of said level adjusting means in response to an increase in the level of the input signal and to increase the gain of said level adjusting means in response to a decrease in the level of the input signal.

In an embodiment of noise reduction circuit thus constituted, the noise suppressing signal is produced by the level limiter to which the signal component containing noise extracted by the filter from the input signal is supplied. The noise suppressing signal, after being adjusted in level by the level adjuster, is added with reversed polarity to the input signal in the signal subtracter, so that the noise contained in the input signal is suppressed. The first and second control signals are produced by the control signal generator on the basis of the detection signal produced by the level detector representing the level of the input signal. These control signals are used respectively for controlling the limit level of the level limiter in accordance with the level of the input signal and for controlling the gain of the level adjuster in accordance with the level of the input signal.

As indicated above, the limit level of the level limiter is varied in response to the level of the input signal, and the gain of the level adjuster is varied also in response to the level of the input signal. Therefore, the noise suppressing signal supplied to the signal subtracter includes mainly the noise separated from the input signal and has a level corresponding to the level of the noise contained in the input signal in both a situation wherein the level of the noise contained in the input signal is relatively low and a situation wherein the level of the noise contained in the input signal is relatively high. Moreover, the input signal is subjected to noise suppression with no noticeable loss of a part of the output signal when the level of the noise contained in the input signal is relatively low, and the noise contained in the input signal is suppressed sufficiently in the output signal when the level of the noise contained in the input signal is relatively high.

The invention will now be described by way of example with reference to the accompanying drawings, throughout which like parts are referred to by like references, and in which:
Figure 1 is a block diagram of a previously proposed noise reduction circuit;
Figure 2 is a circuit diagram showing a level limiter in the circuit of Figure 1;
Figure 3 is a graph showing an input-output characteristic of the level limiter of Figure 2;
Figure 4 is a block diagram of one embodiment of noise reduction circuit in accordance with the present invention;
Figure 5 is a circuit diagram showing a variable level limiter in the embodiment of Figure 4;
Figure 6 is a graph showing an input-output characteristic of the variable level limiter of Figure 5; and
Figure 7 is a block diagram of another embodiment of noise reduction circuit in accordance with the present invention.

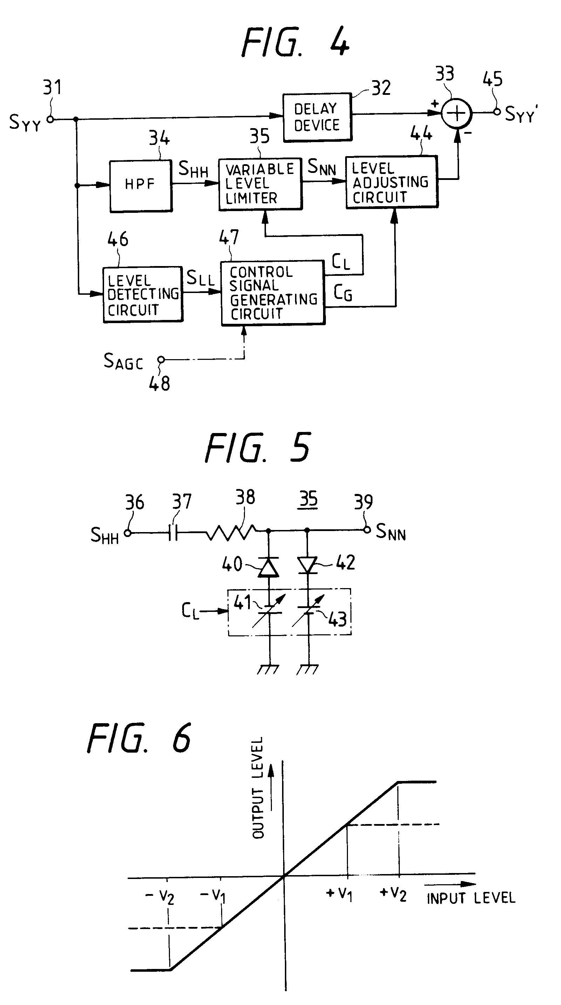

Referring to Figure 4, the embodiment is intended to reduce noise contained in a luminance signal forming a part of a composite video signal. A luminance signal SYY supplied to an input terminal 31 is passed through a delay device 32 to a subtracter 33 and also to a high pass filter (HPF) 34, and a high frequency component SHH of the luminance signal SYY which contains noise is extracted from the HPF 34. The high frequency component SHH from the HPF 34 is supplied to a variable level limiter 35.

As Figure 5 shows, the variable level limiter 35 comprises, for example, an input terminal 36 to which the high frequency component SHH is applied, a capacitor 37 and a resistor 38 connected in series to the terminal 36, an output terminal 39 connected to the terminal 36 through the series-connected capacitor 37 and a resistor 38, a first serial connection of a diode 40 and a variable voltage source 41, and a second serial connection of a diode 42 and a variable voltage source 43. The first and second serial connections 40, 41 and 42, 43 are connected in parallel with each other between the terminal 39 and a reference potential terminal which may, for example, be earthed. The diode 40 has its cathode coupled to the terminal 39 and its anode coupled to the variable voltage source 41, which supplies the anode of the diode 40 with a variable negative bias voltage, and the diode 42 has its anode coupled to the terminal 39 and its cathode coupled to the variable voltage source 43, which supplies the cathode of the diode 42 with a variable positive bias voltage.

The variable level limiter 35 has an input-output characteristic as shown in Figure 6 under a condition in which each of the negative and positive bias voltages supplied respectively by the variable voltage sources 41 and 43 is of the same absolute value. According to the characteristic shown in Figure 6, with a negative bias voltage of a relatively small absolute value supplied to the diode 40 from the variable voltage source 41 and a positive bias voltage of a relatively small absolute value supplied to the diode 42 from the variable voltage source 43, an output level proportional to the input level is obtained so long as the input level is equal to or lower than +v1 and equal to or higher than -v1, and an output level having a constant positive or negative value is obtained when the input level is higher than +v1 or lower than -v1. When a negative bias voltage of a relatively large absolute value is supplied to the diode 40 from the variable voltage source 41 and a positive bias voltage of a relatively large absolute value is supplied to the diode 42 from the variable voltage source 43, an output level proportional to the input level is obtained so long as the input level is equal to or lower than +v2 (which is higher than +v1) and equal to or higher than -v2 (which is lower than -v1), and an output level having a constant positive or negative value is obtained when the input level is higher than +v2 or lower than -v2.

In the circuit of Figure 5, each of the limit levels applied to the variable level limiter 35 is varied in response to variations in the negative or positive bias voltages supplied from the variable voltage source 41 or 43 in such a manner as to have an absolute value that increases or decreases in proportion to the absolute value of the negative or positive bias voltage. Therefore, the level width of the variable level limiter 35 through which a signal passes without being limited in level is broadened or narrowed in proportion to the absolute value of each of the negative and positive bias voltages supplied respectively from the variable voltage sources 41 and 43.

In the variable level limiter 35, the high frequency component SHH of the luminance signal SYY is caused to pass through the level width of the variable level limiter 35 which is defined by the limit levels set in response to the negative and positive bias voltages supplied from the variable voltage sources 41 and 43. A signal which includes mainly noise having a relatively low level in the high frequency component SHH is derived from the high frequency component SHH at the terminal 39 as a noise suppressing signal SNN. This noise suppressing signal SNN is adjusted in level by a level adjusting circuit 44 as indicated in Figure 4 and is then supplied to the subtracter 33.

In the subtracter 33, the level-adjusted noise suppressing signal SNN is added with reversed polarity to (that is, subtracted from) the luminance signal SYY from the terminal 31. The signal SYY is delayed by the delay device 32 so that, as supplied to the subtracter 33, it coincides in time with the noise suppressing signal SNN. The noise contained in the luminance signal SYY is therefore cancelled by the noise suppressing signal SNN. As a result, a luminance signal SYY′ in which noise is suppressed is obtained from the subtracter 33 to be supplied to an output terminal 45.

The luminance signal SYY is also supplied to a level detecting circuit 46. The level detecting circuit 46 comprises a portion forming a low-pass filter (LPF) to which the luminance signal SYY is applied, and a portion generating a signal having a level corresponding to an output level of the portion forming the LPF for detecting an average level of the luminance signal SYY and producing a detection output signal SLL representing the average level of the luminance signal SYY. The signal SLL is supplied to a control signal generating circuit 47.

The control signal generating circuit 47 is operative to produce a limit level control signal CL and a gain control signal CG on the basis of the detection output signal SLL obtained from the level detecting circuit 46. The control signal generating circuit 47 supplies the variable level limiter 35 and the level adjusting circuit 44 with the limit level control signal CL and the gain control signal CG, respectively, so as to vary each of the limit levels applied to the variable level limiter 35 and the gain of the level adjusting circuit 44 in response to the detection output signal SLL.

In order for the control signal generating circuit 47 to control the limit levels applied to the variable level limiter 35, the limit level control signal CL from the control signal generating circuit 47 is applied to control terminals of the variable voltage sources 41 and 43 (Figure 5) to cause the negative and positive bias voltages supplied from the variable voltage sources 41 and 43 to vary in response to the detection output signal SLL. The control of the limit levels is performed in such a manner that each of the limit levels which is applied to the variable level limiter 35 when the average level of the luminance signal SYY represented by the detecting output signal SLL is relatively high (and therefore the level of the noise contained in the luminance signal SYY is relatively low) is smaller in absolute value than that applied to the variable level limiter 35 when the average level of the luminance signal SYY is relatively low (and therefore the level of the noise contained in the luminance signal SYY is relatively high).

As indicated above, the limit levels applied to the variable level limiter 35 are varied in response to variations in the average level of the luminance signal SYY represented by the detection output signal SLL. When the level of the noise contained in the frequency component SHH obtained from the HPF 34 is relatively low, the noise suppressing signal SNN obtained from the variable level limiter 35 is constituted by the high frequency component SHH having passed through the relatively narrow level width of the variable level limiter 35 which is defined by limit levels set to have relatively small absolute values. The noise suppressing signal SNN in this case therefore includes mainly the noise contained within relatively low levels in the high frequency component SHH and a small amount of high frequency component of the luminance signal SYY. On the other hand, when the level of the noise contained in the high frequency component SHH obtained from the HPF 34 is relatively high, the noise suppressing signal SNN obtained from the variable level limiter 35 is constituted by the high frequency component SHH having passed through the relatively broad level width of the variable level limiter 35 which is defined by limit levels set to have relatively large absolute values. The noise suppressing signal SNN in this case therefore includes the noise contained within a relatively broad level width in the high frequency component SHH.

The control of the gain of the level adjusting circuit 44 is carried out by the gain control signal CG supplied to control terminals of the level adjusting circuit 44 by the control signal generating circuit 47. The control is carried out in such a manner that the gain of the level adjusting circuit 44 that is set when the average level of the luminance signal SYY representing by the detection output signal SLL is relatively high (and therefore the level of the noise contained in the luminance signal SYY is relatively low) is less than the gain of the variable level limiter 35 when the average level of the luminance signal SYY is relatively low (and therefore the level of the noise contained in the luminance signal SYY is relatively high).

The gain of the level adjusting circuit 44 is varied in response to variations in the average level of the luminance signal SYY represented by the detection output signal SLL as mentioned above. The noise suppressing signal SNN obtained from the variable level limiter 35 is therefore adjusted in level by the level adjusting circuit 44 with a relatively small gain when the level of the noise contained in the high frequency component SHH obtained from the HPF 34 is relatively low and with a relatively large gain when the level of the noise contained in the high frequency component SHH obtained from the HPF 34 is relatively low.

Control of the limit level applied to the variable level limiter 35 and control of the gain of the level adjusting circuit block 44 are carried out respectively in accordance with the limit level control signal CL and the gain control signal CG from the control signal generating circuit block 47 in the manner described above. The noise suppressing signal SNN supplied to the subtracter 33 therefore includes mainly the noise contained in the high frequency component SHH and a small amount of high frequency component of the luminance signal SYY and is adjusted to have a relatively low level when the level of the noise contained in the luminance signal SYY is relatively low. On the other hand, the signal SNN includes in substantial measure the noise contained in the high frequency component SHH and is adjusted to have a relatively high level when the level of the noise contained in the luminance signal SYY is relatively high.

Consequently, the luminance signal SYY′ in which the noise is suppressed is generated by the subtracter 33 and supplied to the terminal 45 without noticeably losing any of the high frequency component thereof when the level of the noise contained in the luminance signal SYY which is supplied to the terminal 31 is relatively low. Moreover, when the level of the noise contained in the luminance signal SYY which is supplied to the terminal 31 is relatively high, the noise is well suppressed in the luminance signal SYY′ generated by the subtracter 33 and supplied to the terminal 45.

In the case where the embodiment shown in Figure 4 is applied to a video signal processing circuit arrangement of a video camera, an AGC error signal SAGC which is used for an automatic gain control (AGC) for a luminance signal in the video signal processing circuit may be supplied through a control terminal 48 to the control signal generating circuit 47 in addition to the detection output signal SLL obtained from the level detecting circuit 46. This is shown with a dot-dash line in Figure 4. In such a case, the limit level control signal CL and the gain control signal CG are produced in response to both the detection output signal SLL obtained from the level detecting circuit 46 and the AGC error signal SAGC. The signals CL and CG therefore respond more faithfully to variations in the level of the luminance signal SYY. The signals CL and CG are supplied to the variable level limiter 35 and the level adjusting circuit 44, respectively, from the control signal generating circuit 47, as indicated above. As a result of this the control of the limit levels applied to the variable level limiter 35 and of the gain of the level adjusting circuit 44 is significantly improved.

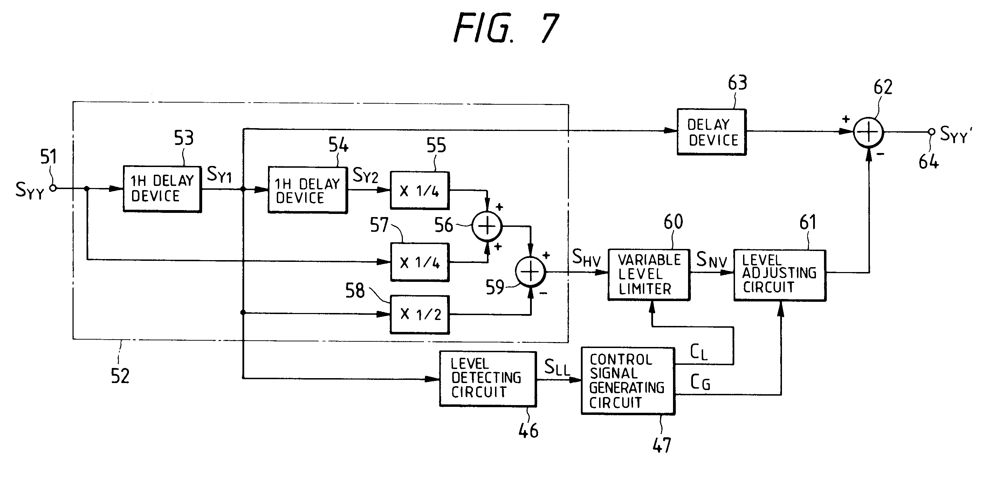

Figure 7 shows another embodiment of a noise reduction circuit in accordance with the present invention for the suppression of noise contained in a luminance signal forming a part of a composite video signal.

A luminance signal SYY is supplied via an input terminal 51 to a vertical HPF 52. In the vertical HPF 52, the luminance signal SYY from the terminal 51 is delayed by a 1H delay device 53 providing a delay of one line period (1H) to produce a delayed luminance signal SY1 and then delayed further by a 1H delay device 54 to produce a delayed luminance signal SY2. The delayed luminance signal SY2, which has a delay of 2H, is multiplied by a factor of one quarter by an attenuator 55. Similarly, the luminance signal SYY from the terminal 51 is attenuated in level to one quarter by an attenuator 57, and the output of the attenuator 57 is added to the output of the attenuator 55 in an adder 56. The delayed luminance signal SY1 obtained from the 1H delay device 53 is attenuated in level to one half by an attenuator 58, and the output of the attenuator 58 is added with reversed polarity to the output of the adder 56 in a subtracter 59 to produce a signal component SHV containing line-correlation noise which is derived on the basis of vertical correlation of the video signal.

The signal component SHV thus extracted from the luminance signal SYY by the vertical HPF 52 is supplied to a variable level limiter 60 which corresponds to the variable level limiter 35 shown in Figures 4 and 5, and a noise suppressing signal SNV is derived from the variable level limiter 60. The noise suppressing signal SNV obtained from the variable level limiter 60 is supplied to a level adjusting circuit 61 which corresponds to the level adjusting circuit 44 shown in Figure 4. The signal SNV is adjusted in level by the level adjusting circuit 61 and then supplied to a subtracter 62.

In the subtracter 62, the level-adjusted noise suppressing signal SNV is added with reversed polarity to the delayed luminance signal SY1 obtained from the 1H delay device 53. The delayed luminance signal SY1 is further delayed by a delay device 63 so as to coincide in time with the level adjusted noise suppressing signal SNV and then supplied to the subtracter 62. Thus the line-correlation noise contained in the delayed luminance signal SY1 is cancelled by the noise suppressing signal SNV. As a result, a luminance signal SYY′ in which line-correlation noise is suppressed is obtained from the subtracter 62 and supplied to an output terminal 64.

In this embodiment, the delayed luminance signal SY1 is supplied also to the level detecting circuit 46, and a detection output signal SLL representing an average level of the luminance signal SYY supplied to the terminal 51 is derived by the level detecting circuits 46 and supplied to the control signal generating circuit 47. From the control signal generating circuit 47, a limit level control signal CL and a gain control signal CG formed on the basis of the detection output signal SLL are supplied to the variable level limiter 60 and the level adjusting circuit 61, respectively, so that each of the limit levels applied to the variable level limiter 60 and the gain of the level adjusting circuit 61 are varied in response to the detection output signal SLL. As a result, advantages which are the same as those of the embodiment of Figure 4 are also obtained in the embodiment of Figure 7.

Thus embodiments of the invention provide a highly-effective noise reduction circuit for suppressing noise contained in a signal having a relatively broad frequency band, such as the luminance signal portion of a composite video signal. Such embodiments avoid the problems and disadvantages of the previously proposed circuit described above. In particular, it enables noise suppression without noticeably losing a part of the input signal when the level of the noise contained in the input signal is relatively low, and the noise contained in the input signal is suppressed sufficiently to produce a low-noise output signal when the level of the noise contained in the input signal is relatively high.

## Claims

1. A noise reduction circuit for reducing noise contained in an input signal, the circuit comprising:
input means (31) for receiving an input signal that includes a signal component containing noise;
filter means (34) connected to said input means (31) for receiving the input signal and extracting the signal component containing noise from the input signal;
level limiting means (35) connected to said filter means (34) for limiting a level of the signal component extracted by said filter means (34) to produce a noise suppressing signal;
level adjusting means (44) connected to said level limiting means (35) for adjusting a level of the noise suppressing signal;
signal subtracting means (33) connected to said input means (31) and said level adjusting means (44) and responsive to the input signal and the noise suppressing signal from said level adjusting means (44) so that the noise suppressing signal is added with reversed polarity to the input signal so as to suppress the noise contained in the input signal; and
output means (45) connected to said signal subtracting means (33) for supplying an output signal derived from said signal subtracting means (45);
characterized by:
said level limiting means (35) being a variable level limiting means (35);
level detecting means (46) connected to said input means (31) for receiving the input signal and producing a detection signal indicating a level of the input signal; and
control signal generating means (47) connected to said level detecting means (46) for generating first and second control signals in response to said detection signal, supplying said first control signal to said variable level limiting means (35) so as to control a limit level of said variable level limiting means (35), and supplying said second control signal to said level adjusting means (44) so as to control a gain of said level adjusting means (44), wherein said control signal generating means (47) adjusts said first control signal so as to decrease an absolute value of said limit level in response to an increase in the level of the input signal and to increase the absolute value of said limit level in response to a decrease in the level of the input signal, and adjusts said second control signal so as to decrease the gain of said level adjusting means (44) in response to an increase in the level of the input signal and to increase the gain of said level adjusting means (44) in response to a decrease in the level of the input signal.

2. A circuit according to claim 1 wherein said variable level limiting means (35) comprises a pair of diodes (40, 42) coupled in anti-parallel with each other in relation to an output of said filter means (34) and biasing means (41, 43) operative to supply said diodes (40, 42) with bias voltages respectively controlled by the first control signal.

3. A circuit according to claim 2 wherein said biasing means (41, 43) comprises a first variable voltage source (41) for supplying one of said diodes (40) with a negative bias voltage and a second variable voltage source (43) for supplying the other of said diodes (42) with a positive bias voltage, each of said negative and positive bias voltages (41, 43) being varied in response to the first control signal.

4. A circuit according to claim 1 wherein said filter means (34) comprises a high pass filter (34) for extracting a high frequency component from the input signal.

5. A circuit according to any one of the preceding claims wherein said input signal comprises a luminance signal forming a part of a composite video signal.

6. A circuit according to claim 5 wherein said level detecting means (46) detects an average level of the luminance signal.

7. A circuit according to claim 5 wherein said filter means (52) comprises a first 1H delay device (53) supplied with the luminance signal, a second 1H delay device (54) connected in series with said first 1H delay device (53), a first adder (56) supplied with said luminance signal and an output of said second 1H delay device, and a second adder (59) supplied with an output of said first 1H delay device (53) and an output of said first adder (56) to produce said signal component.

8. A circuit according to claim 1 wherein said input signal comprises a luminance signal forming a part of a composite video signal generated by a video camera having automatic gain control means and means for generating an automatic gain control error signal, and said control signal generating means (47) is jointly responsive to said level detecting means (46) and said automatic gain control error signal for generating said first and second control signals.

## Patentansprüche

1. Rauschvermindernde Schaltung zur Verringerung von in einem Eingangssignal enthaltenem Rauschen, wobei die Schaltung aufweist:
eine Eingangseinrichtung (31) zum Empfang eines Eingangssignals, das einen verrauschten Signalanteil enthält,
eine Filtereinrichtung (34), die mit der Eingangseinrichtung (31) verbunden ist, zum Empfang des Eingangssignals und Gewinnung des verrauschten Signalanteils aus dem Eingangssignal,
eine pegelbegrenzende Einrichtung (35), die mit der Filtereinrichtung (34) verbunden ist, zur Begrenzung eines Pegels des Signalanteils, der durch die Filtereinrichtung (34) gewonnen ist, zur Erzeugung eines rauschunterdrückenden Signals,
eine pegelstellende Einrichtung (44), die mit der pegelbegrenzenden Einrichtung (35) verbunden ist, zur Einstellung eines Pegels des rauschunterdrückenden Signals,
eine Signal-Subtraktionseinrichtung (33), die mit der Eingangseinrichtung (31) und der pegelstellenden Einrichtung (44) verbunden ist und so auf das Eingangssignal und das rauschunterdrückende Signal von der pegelstellenden Einrichtung (44) reagiert, daß das rauschunterdrückende Signal mit invertierter Polarität zu dem Eingangssignal addiert wird, so daß in dem Eingangssignal enthaltendes Rauschen unterdrückt wird, und
eine Ausgangseinrichtung (45), die mit der Signal-Subtraktionseinrichtung (33) verbunden ist, zur Bereitstellung eines Ausgangssignals, das von der Signal-Subtraktionseinrichtung (45) abgeleitet ist,
**dadurch gekennzeichnet**,
daß die pegelbegrenzende Einrichtung (35) eine veränderbare pegelbegrenzende Einrichtung (35) ist,
eine pegelerfassende Einrichtung (46) mit der Eingangseinrichtung (31) zum Empfang des Eingangssignals und Erzeugung eines Erfassungssignals verbunden ist, das einen Pegel des Eingangssignals anzeigt, und
eine ein Steuersignal erzeugende Einrichtung (46) mit der pegelerfassenden Einrichtung (46) verbunden ist zur Erzeugung eines ersten und zweiten Steuersignals abhängig von dem Erfassungssignal, zur Verfügungstellung des ersten Steuersignals an die pegelbegrenzende Einrichtung (35) zur Steuerung eines Grenzpegels der veränderbaren pegelbegrenzenden Einrichtung (35), und zur Verfügungstellung des zweiten Steuersignals an die pegelstellende Einrichtung (44) zur Steuerung einer Verstärkung der pegelstellenden Einrichtung (44), wobei die Steuersignal erzeugende Einrichtung (47) das erste Steuersignal so einstellt, daß es einen Absolutwert eines Grenzpegels abhängig von einem Ansteigen des Pegels des Eingangssignals herabsetzt und den Absolutwert des Grenzpegels abhängig von einem Abfallen des Pegels des Eingangssignals vergrößert, und das zweite Steuersignal so einstellt, daß es die Verstärkung der pegelstellenden Einrichtung (44) abhängig von einem Ansteigen des Pegels des Eingangssignals herabsetzt und die Verstärkung der pegelstellenden Einrichtung (44) abhängig von einem Abfall des Pegels des Eingangssignals erhöht.

2. Schaltung nach Anspruch 1,
**dadurch gekennzeichnet**,
daß die veränderbare pegelbegrenzende Einrichtung (35) ein Diodenpaar (40, 42) aufweist, das anti-parallel zueinander bezüglich eines Ausgangs der Filtereinrichtung (34) miteinander verbunden ist und eine Vorspannungseinrichtung (41, 43) zur jeweiligen Versorgung der Dioden (40, 42) mit einer Versorgungsspannung, die durch das erste Steuersignal gesteuert ist.

3. Schaltung nach Anspruch 2,
**dadurch gekennzeichnet**,
daß die Vorspannungseinrichtung (41, 43) eine erste veränderbare Spannungsquelle (41) zur Versorung einer der Dioden (40) mit einer negativen Vorspannung und eine zweite veränderbare Spannungsquelle (43) aufweist zur Versorgung der anderen der Dioden (42) mit einer positiven Vorspannung, wobei jede der negativen und positiven Vorspannung (41, 43) abhängig von dem ersten Steuersignal verändert wird.

4. Schaltung nach Anspruch 1,
**dadurch gekennzeichnet**,
daß die Filtereinrichtung (34) ein Hochpaßfilter (34) zur Gewinnung eines Hochfrequenzanteils des Eingangssignals aufweist.

5. Schaltung nach einem der vorhergehenden Ansprüche,
**dadurch gekennzeichnet**,
daß das Eingangssignal ein Luminanzsignal aufweist, das einen Teil eines zusammengesetzten Videosignals bildet.

6. Schaltung nach Anspruch 5,
**dadurch gekennzeichnet**,
daß die pegelerfassende Einrichtung (46) einen Durchschnittspegel des Luminanzsignals erfaßt.

7. Schaltung nach Anspruch 5,
**dadurch gekennzeichnet**,
daß die Filtereinrichtung (52) eine erste Einzeilen-Verzögerungseinrichtung (53) aufweist, an die das Luminanzsignal gegeben wird, eine zweite Einzeilen-Verzögerungseinrichtung (54), die in Reihe zu der ersten Einzeilen-Verzögerungseinrichtung (53) geschaltet ist, einen ersten Addierer (56), an den das Luminanzsignal und ein Ausgangssignal der zweiten Einzeilen-Verzögerungseinrichtung gegeben wird, und einen zweiten Addierer (59), der mit einem Ausgangssignal der ersten Einzeilen-Verzögerungseinrichtung (53) und einem Ausgangssignal des ersten Addierers (56) versorgt ist, zur Erzeugung des Signalanteils.

8. Schaltung nach Anspruch 1,
**dadurch gekennzeichnet**,
daß das Eingangssignal ein Luminanzsignal aufweist, das einen Teil eines zusammengesetzten Videosignals bildet, das durch eine Videokamera mit einer automatischen Verstärkungsregelungseinrichtung erzeugt wird und einer Einrichtung zur Erzeugung eines automatischen Verstärkungsregelungs-Fehlersignals, und daß die Steuersignal erzeugende Einrichtung (47) gemeinsam auf die pegelerfassende Einrichtung (46) und das automatische Verstärkungsregelungs-Fehlersignal zur Erzeugung eines ersten und zweiten Steuersignals reagiert.

## Revendications

1. Un circuit de réduction de bruit pour réduire du bruit contenu dans un signal d'entrée, le circuit comprenant :
des moyens d'entrée (31) pour recevoir un signal d'entrée, qui inclut une composante de signal contenant du bruit ;
des moyens de filtre (34), reliés auxdits moyens d'entrée (31), pour recevoir le signal d'entrée et extraire la composante de signal contenant du bruit à partir du signal d'entrée ;
des moyens de limitation de niveau (35) reliés auxdits moyens de filtre (34), pour limiter un niveau de la composante de signal extraite par lesdits moyens de filtre (34), afin de produire un signal de suppression de bruit ;
des moyens d'ajustement de niveau (44) reliés auxdits moyens de limitation de niveau (35), pour ajuster un niveau du signal de suppression de bruit ;
des moyens de soustraction de signal (33) reliés auxdits moyens d'entrée (31) et auxdits moyens d'ajustement de niveau (44), et réagissant au signal d'entrée et au signal de suppression de bruit à partir desdits moyens d'ajustement de niveau (44), de sorte que le signal de suppression de bruit est ajouté, avec polarité inversée, au signal d'entrée, de façon à supprimer le bruit contenu dans le signal d'entrée ; et
des moyens de sortie (45) reliés auxdits moyens de soustraction de signal (33), pour fournir un signal de sortie dérivé à partir desdits moyens de soustraction de signal (45) ;
caractérisé par :
desdits moyens de limitation de niveau (35) étant des moyens de limitation de niveau variable (35) ;
des moyens de détection de niveau (46) reliés auxdits moyens d'entrée (31), pour recevoir le signal d'entrée et produire un signal de détection indiquant un niveau du signal d'entrée ; et
des moyens de génération de signal de commande (47) reliés auxdits moyens de détection de niveau (46), pour générer des premier et second signaux de commande en réponse audit signal de détection, fournissant ledit signal de commande auxdits moyens de limitation de niveau variable (35), de façon à commander un niveau de limite desdits moyens de limitation de niveau variable (35), et fournissant ledit second signal de commande auxdits moyens d'ajustement de niveau (44), de façon à commander un gain desdits moyens d'ajustement de niveau (44), où, lesdits moyens de génération de signal de commande (47) ajustent ledit premier signal de commande, de façon à diminuer une valeur absolue dudit niveau de limite, en réponse à une augmentation dans le niveau du signal d'entrée, et afin d'augmenter la valeur absolue dudit niveau de limite, en réponse à une diminution dans le niveau du signal d'entrée, et ajustent ledit second signal de commande, de façon à diminuer le gain desdits moyens d'ajustement de niveau (44), en réponse à une augmentation dans le niveau du signal d'entrée, et afin d'augmenter le gain desdits moyens d'ajustement de niveau (44), en réponse à une diminution dans le niveau du signal d'entrée.

2. Un circuit selon la revendication 1, dans lequel lesdits moyens de limitation de niveau variable (35) comprennent une paire de diodes (40, 42), couplées de façon antiparallèle, l'une avec l'autre, en relation à une sortie desdits moyens de filtre (34), et des moyens de polarisation (41, 43) opérant afin de fournir auxdites diodes (40, 42) des tensions de polarisation, respectivement, commandés par le premier signal de commande.

3. Un circuit selon la revendication 2, dans lequel lesdits moyens de polarisation (41, 43) comprennent une première source de tension variable (41), pour fournir à l'une desdites diodes (40) une tension de polarisation négative, et une seconde source de tension variable (43), pour fournir à l'autre desdites diodes (42) une tension de polarisation positive, chacune desdites tensions de polarisation négative et positive (41, 43) étant amenée à varier en réponse au premier signal de commande.

4. Un circuit selon la revendication 1, dans lequel lesdits moyens de filtre (34) comprennent un filtre passe-haut (34) pour extraire une composante de fréquence élevée à partir du signal d'entrée.

5. Un circuit selon une quelconque des précédentes revendications, dans lequel ledit signal d'entrée comprend un signal de luminance formant une partie d'un signal vidéo composite.

6. Un circuit selon la revendication 5, dans lequel lesdits moyens de détection de niveau (46) détectent un niveau moyen du signal de luminance.

7. Un circuit selon la revendication 5, dans lequel lesdits moyens de filtre (52) comprennent un dispositif de retard de 1H (53) alimenté avec le signal de luminance, un second dispositif de retard de 1H (54) relié en série avec ledit premier dispositif de retard de 1H (53), un premier additionneur (56) alimenté avec ledit signal de luminance et une sortie dudit second dispositif de retard de 1H, et un second additionneur (59) alimenté avec une sortie dudit premier dispositif de retard de 1H (53) et une sortie dudit premier additionneur (56), afin de produire ladite composante de signal.

8. Un circuit selon la revendication 1, dans lequel ledit signal d'entrée comprend un signal de luminance formant une partie d'un signal vidéo composite, généré par un appareil de prise de vue vidéo, ayant des moyens de commande de gain automatique et des moyens pour générer un signal d'erreur de commande de gain automatique, et lesdits moyens de génération de signal de commande (47) réagissent conjointement auxdits moyens de détection de niveau (46) et audit signal d'erreur de commande de gain automatique, pour générer lesdits premier et second signaux de commande.
